# FASCICULE DE BREVET EUROPEEN

(11) **EP 3 403 268 B1**
(45) Date de publication et mention de la délivrance du brevet: **18.11.2020**
(21) Numéro de dépôt: 17711699.3
(22) Date de dépôt: 05.01.2017
(51) Int. Cl.: H01F 7/20, G11C 29/50, G01R 33/12, G11C 29/56

(54) **GENERATEUR DE CHAMP MAGNETIQUE**
MAGNETFELDGENERATOR
MAGNETIC FIELD GENERATOR

(30) Priorité: 11.01.2016 FR 1650184
(43) Date de publication de la demande: 21.11.2018
(73) Titulaire: Centre National de la Recherche Scientifique, 75016 Paris (FR); Commissariat à l'Energie Atomique et aux Energies Alternatives, 75015 Paris (FR)
(72) Inventeur: JOUMARD, Isabelle, 38120 Saint Egreve (FR); SOUSA, Ricardo, 38000 Grenoble (FR)
(74) Mandataire: Lavoix
(86) Numéro de dépôt international: PCT/FR2017/050034
(87) Numéro de publication internationale: WO 2017/121947

(56) Documents cités:
- EP-A1- 2 835 688
- WO-A1-2015/135513
- DE-A1-102008 020 445
- JP-A- H08 264 604

## Description

La présente demande de brevet revendique la priorité de la demande de brevet français FR16/50184 qui sera considérée comme faisant partie intégrante de la présente description.

### Domaine

La présente demande concerne le domaine des générateurs de champ magnétique, et plus particulièrement un dispositif générant un champ magnétique réglable en intensité et en direction.

### Exposé de l'art antérieur

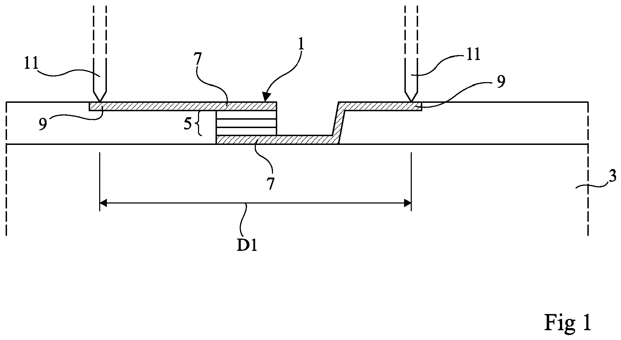

La figure 1 représente un exemple de point mémoire magnétique 1 dont on souhaite vérifier des caractéristiques.

Le point mémoire 1 est formé sur une plaquette de silicium 3. La plaquette de silicium 3 est fixée sur un dispositif de positionnement en X, Y et Z, non représenté, d'un équipement de test. Ce dispositif permet de positionner la plaquette avec une précision de l'ordre du micromètre. Le point mémoire comprend des portions 5 de couches conductrices et magnétiques situées entre deux portions de couches métalliques 7. Les portions de couches métalliques se prolongent par des contacts 9 situés dans un même plan horizontal de part et d'autre du point mémoire. Il peut cependant y avoir une différence de quelques micromètres entre les niveaux des contacts.

Pour tester le point mémoire, on positionne des pointes de test 11 sur les contacts 9, la distance D1 entre les pointes de test 11 étant de l'ordre d'une centaine de micromètres. Un champ magnétique d'intensité et de direction réglables est appliqué au point mémoire. Les variations de résistance électrique entre les pointes de test en fonction de l'intensité et de la direction du champ magnétique permettent de caractériser le point mémoire 1.

On note que, pour positionner les pointes de test 11 et créer le champ magnétique, seul l'espace situé au-dessus de la plaquette de silicium est disponible, l'espace situé sous la plaquette étant utilisé par le dispositif de positionnement.

On souhaite donc disposer d'un générateur de champ magnétique permettant de produire un champ magnétique d'intensité et de direction réglables, ce générateur restant entièrement situé au-dessus de la surface de la plaquette contenant le point mémoire.

Plus généralement, on cherche à plonger dans un champ magnétique orientable des composants disposés sur une plaquette dont un seul côté est disponible pour générer le champ magnétique.

Les documents EP 2 835 688 A1, WO 2015/135513 A1 et DE 10 2008 020445 A1 décrivent chacun un générateur d'un champ magnétique comprenant un circuit magnétique comportant deux extrémités polaires disposées symétriquement sur un plan horizontal et des bobines disposées autour du circuit magnétique et permettant de générer un champ magnétique seulement dans une direction.

De même, le document JP H08-264604 A décrit un générateur d'un champ magnétique comprenant un circuit magnétique comportant une extrémité polaire d'axe vertical passant à travers une bobine et permettant de générer un champ magnétique seulement dans une direction.

Les dispositifs connus de génération dans un demi espace d'un champ magnétique ne permettent pas de régler chaque composante verticale ou horizontale du champ magnétique indépendamment des autres composantes et posent divers problèmes de mise en oeuvre.

On souhaite donc disposer d'un générateur de champ magnétique permettant de produire dans un demi espace un champ magnétique dont chaque composante verticale et horizontale peut être réglée indépendamment.

### Résumé

Ainsi, un mode de réalisation prévoit un générateur selon la revendication 1.

Selon différents modes de réalisation, le générateur comprend une ou plusieurs des caractéristiques optionnelles des revendications 2 à 10.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles
La figure 1 représente un exemple de point mémoire magnétique ;
la figure 2A est une vue en perspective d'un mode de réalisation d'un circuit magnétique ;
la figure 2B est une vue de dessous d'une partie du circuit magnétique représenté en figure 2A ;
la figure 2C est une vue de côté d'une partie d'un circuit magnétique positionné au-dessus d'une plaquette à tester ;
la figure 3 est une illustration simplifiée du circuit magnétique représenté en figure 2A et de bobines parcourues par des courants ;
la figure 4A est une vue en perspective d'un mode de réalisation simplifié d'un générateur de champ magnétique
la figure 4B est une vue de dessous d'une partie du générateur de la figure 4A ; et
la figure 5 est une vue de dessous partielle d'une variante de circuit magnétique.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, des circuits d'alimentation de bobines ne sont pas représentés.

Dans la description qui suit, sauf précision contraire, lorsque l'on fait référence à des qualificatifs de position absolue, tels que les termes "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation de l'élément concerné dans la figure visée. Sauf précision contraire, l'expression "de l'ordre de" signifie, s'agissant d'une orientation, à 10 degrés près, de préférence à 5 degrés près.

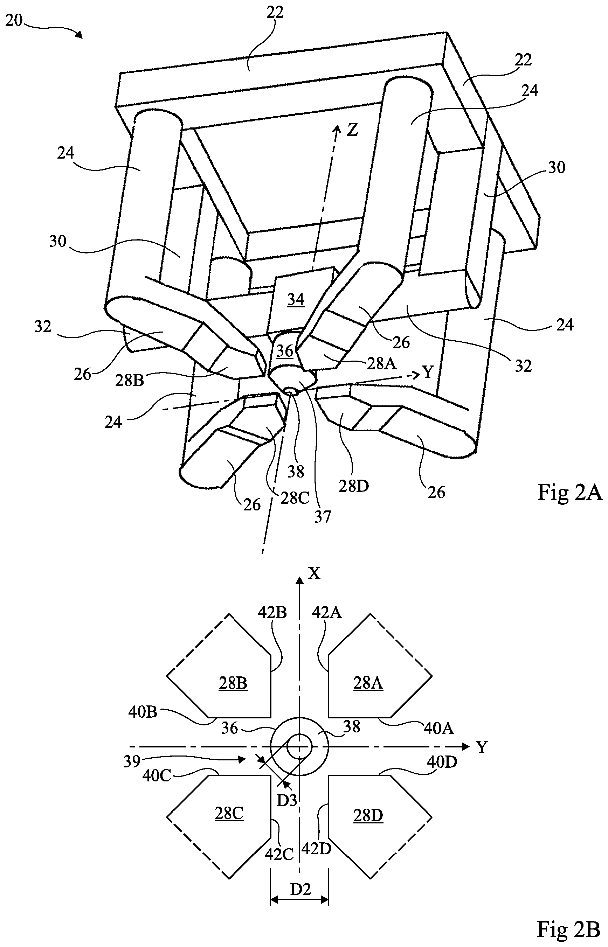

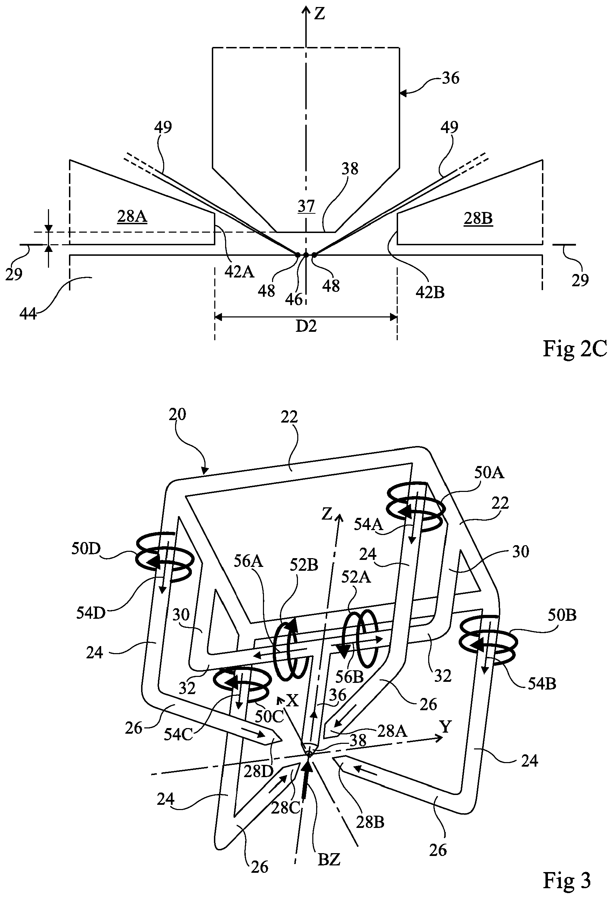

La figure 2A est une vue en perspective d'un mode de réalisation d'un circuit magnétique 20 d'un générateur de champ magnétique. Le générateur comprend des bobines, non représentées en figure 2A, disposées autour de certaines parties du circuit magnétique. La figure 2B est une vue de dessous, à une échelle différente, d'une partie du circuit magnétique 20 proche de l'axe vertical Z du générateur. La figure 20 est une vue de côté, à une échelle différente, d'une partie du circuit magnétique 20 positionné au-dessus d'une plaquette contenant un point mémoire magnétique à tester.

Le circuit magnétique est réalisé en un matériau ferromagnétique doux, par exemple du fer doux. Le circuit magnétique 20 comprend un cadre carré 22 d'axe Z. Un barreau vertical cylindrique 24 s'étend vers le bas à partir de chacun des coins du cadre 22. Chaque barreau 24 se prolonge vers l'axe Z par un bras radial 26. Chaque bras radial 26 se prolonge par une extrémité polaire respective 28A à 28D en forme de pointe dirigée vers l'axe Z. Les extrémités polaires 28A A 28D ont des faces inférieures situées dans un même plan horizontal 29 (visible en figure 20). A titre d'exemple, le cadre 22 s'inscrit dans un cercle dont le diamètre est compris entre 100 et 200 mm. La dimension selon l'axe Z, ou hauteur, de l'ensemble du circuit est comprise entre 100 et 200 mm. Chaque barreau 24 peut avoir un diamètre compris entre 8 et 20 mm.

Des barreaux 30 s'étendent verticalement vers le bas partir des milieux de deux côtés opposés du cadre 22. Les extrémités des barreaux 30 sont reliées par une tige horizontale 32. Un bloc de liaison 34 centré sur l'axe Z est situé au milieu de la tige 32. Le bloc de liaison 34 se prolonge vers le bas par un bras cylindrique vertical 36. Le bras cylindrique 36 a une extrémité polaire 37 en forme de cône tronqué d'axe Z. Le cône se termine par une face horizontale circulaire 38 située à une hauteur H au-dessus du plan horizontal 29.

En vue de dessous, comme l'illustre la figure 2B, les extrémités polaires 28A à 28D délimitent un espace en forme de croix 39 dont le centre est occupé par l'extrémité polaire 37. La croix est disposée selon des axes horizontaux orthogonaux orientés en X et en Y, l'axe Y étant parallèle à la direction de la tige 32. Ainsi, les extrémités polaires 28A à 28D sont disposées symétriquement par rapport à deux plans verticaux orthogonaux passant par l'axe Z. Les extrémités polaires 28A à 28D peuvent avoir des faces verticales respectives 40A à 40D parallèles à l'axe Y. Les extrémités polaires 28A à 28D peuvent avoir des faces verticales respectives 42A à 42D parallèles à l'axe X. A titre d'exemple, les distances D2 séparant les faces verticales d'extrémités polaires 28A à 28D voisines sont égales et comprises entre 5 et 15 mm.

Le figure 20 est une vue de côté en coupe illustrant une partie inférieure du générateur de champ magnétique en regard d'une plaquette 44 comprenant un point mémoire magnétique 46 muni de contacts 48. La plaquette est fixée à un dispositif de positionnement non représenté. On dispose le générateur de champ magnétique de telle sorte que le plan horizontal 29 du circuit magnétique soit situé au-dessus de la face supérieure de la plaquette 44, le point mémoire étant disposé sous la face 38 de l'extrémité polaire 37. La structure du générateur est telle qu'un espace est disponible pour positionner des pointes de test 49 sur les contacts 48. A titre d'exemple, la hauteur entre le plan horizontal 29 et la face supérieure de la plaquette est comprise entre 0,5 et 5 mm.

La figure 3 est une illustration simplifiée du circuit magnétique 20 représenté en figure 2A et de bobines parcourues par des courants selon un exemple de configuration de courants. Chaque élément du circuit magnétique 20 est représenté sous la forme d'un cylindre allongé selon la direction de propagation d'un flux d'induction magnétique conduit par l'élément. A titre d'exemple, les bobines réelles ont des diamètres extérieurs compris entre 50 et 70 mm. Chaque bobine peut être formée par bobinage d'un fil conducteur en cuivre, le nombre de tours de fil conducteur dépendant du diamètre du fil. Chaque bobine peut comprendre plusieurs centaines de tours de fil conducteur, par exemple entre 200 et 3000 tours.

Autour de chaque barreau 24 associé à l'une des extrémités 28A à 28D, se trouve une bobine respective 50A à 50D. Des bobines 52A et 52B sont disposées autour des parties de la tige 32 situées de part et d'autre de la liaison avec le bras 36. Les bobines 50A à 50D, 52A et 52B peuvent être identiques.

Les bobines sont connectées à des circuits d'alimentation non représentés. Ces circuits permettent de faire circuler un courant de sens et d'intensité choisie dans chaque bobine.

Dans l'exemple de configuration de courants illustrée en figure 3, des courants d'intensité et de sens identiques circulent dans les bobines 50A à 50D de façon à produire dans les barreaux 24 des flux d'induction magnétique 54A à 54D orientés vers le bas. Des courants d'intensité et de sens opposés circulent dans les bobines 52A et 52B. Les courants dans les bobines 52A et 52B produisent des flux d'induction magnétique respectifs 56A et 56B s'éloignant de l'axe Z, d'où il résulte un flux dirigé vers le haut dans le bras vertical 36.

Comme on l'a indiqué précédemment, les extrémités polaires 28A à 28D sont symétriques par rapport à deux plans verticaux orthogonaux passant par l'axe Z. De ce fait, sur l'axe Z vertical, les composantes du champ selon l'axe X et selon l'axe Y s'annulent. Ainsi, le champ magnétique BZ créé sous l'extrémité polaire 37 autour du point mémoire magnétique de la figure 20 est dirigé selon l'axe vertical Z et orienté vers le haut. La forme conique de l'extrémité polaire 37 permet de concentrer dans le cône l'induction magnétique qui se propage dans le bras. Les inventeurs ont montré par des simulations qu'il existe une valeur optimale de la hauteur H séparant le plan 29 de la face 38 qui permet d'obtenir un champ magnétique quasi-uniforme d'intensité maximum sous l'extrémité polaire 37, correspondant par exemple à une induction magnétique supérieure à 0,5 T. A titre d'exemple, la hauteur H est comprise entre 0,5 et 2 mm. La face 38 peut avoir un diamètre compris entre 3 et 7 mm. L'angle entre l'axe Z et la face inclinée du cône peut avoir une valeur comprise entre 40 et 60 degrés. Le bras 36 peut avoir un diamètre compris entre 8 et 20 mm.

On obtient un champ magnétique dirigé selon l'axe Y défini en relation avec la figure 2B et orienté de la gauche vers la droite si, à partir de la configuration de courants de la figure 3, on inverse les sens des courants dans les bobines 50A, 50B et 52A. Dans ce cas, les flux d'induction magnétique produits par les bobines s'annulent dans le bras vertical 36. Comme indiqué précédemment, les extrémités 28A à 28D peuvent avoir des faces verticales respectives 42A à 42D parallèles à l'axe **X.** Cette disposition des faces 42A à 42D permet d'obtenir un champ magnétique quasi-uniforme sans composante selon l'axe X sous la face 38. De plus, la dimension selon l'axe Z ou épaisseur des extrémités polaires 28A à 28D peut être inférieure à l'épaisseur des bras 26, afin d'obtenir un champ magnétique élevé. Les courants dans les bobines 52A et 52B peuvent aussi être annulés, et le générateur produit alors un champ magnétique selon l'axe Y d'intensité réduite.

Un champ magnétique orienté selon l'axe X est obtenu à partir de la configuration de courants illustrée en figure 3 en inversant les sens des courants dans les bobines 50A et 50D et en annulant les courants dans les bobines 52A et 52B. Le fonctionnement est similaire au fonctionnement qui produit un champ orienté selon l'axe **Y.**

D'une manière générale, par des combinaisons de courants d'intensités et de sens choisis circulant dans les bobines, on peut avantageusement choisir l'orientation et l'intensité du champ magnétique sous l'extrémité polaire 37 dans un volume situé sous le plan 29, le générateur de champ magnétique étant entièrement situé au-dessus du plan 29.

Bien que des bobines disposées autour d'éléments du circuit magnétique 20 aient été décrites ci-dessus dans une configuration particulière, d'autres configurations sont possibles. A titre de variante, les bobines 50A à 50D peuvent être remplacées par des bobines situées autour des côtés du cadre 22. Une bobine peut être disposée autour de chaque côté du cadre 22 parallèle à l'axe **Y.** Chaque côté parallèle à l'axe X peut être entouré de deux bobines disposées de part et d'autre du barreau vertical 30. Dans une autre variante, les bobines 52A et 52B peuvent être remplacées par une bobine unique disposée autour du bras 36. Dans ce cas, les barreaux 30 peuvent être supprimés, la tige 32 étant reliée directement aux milieux des côtés du cadre 22 associés.

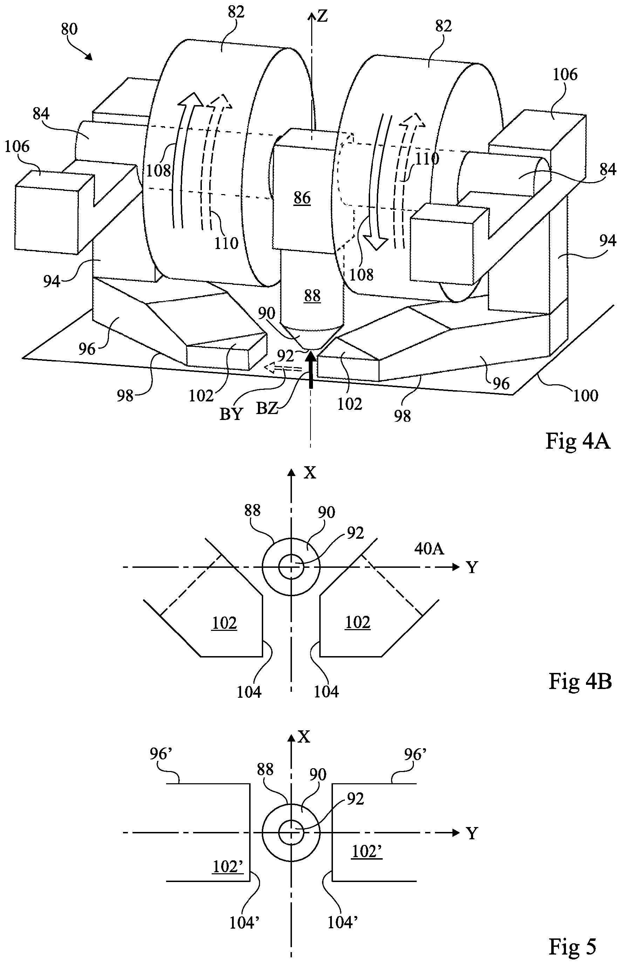

La figure 4A est une vue en perspective d'un mode de réalisation d'un générateur de champ magnétique 80. La figure 4B est une vue de dessous d'une partie du circuit magnétique du générateur 80 proche de l'axe Z.

Le générateur de champ magnétique 80, plus simple que le générateur 20 décrit ci-dessus, permet de fournir un champ magnétique d'intensité choisie orientable dans le plan YZ. Ce générateur comprend deux bobines identiques 82 disposées autour d'une tige horizontale 84 de part et d'autre d'un bloc de liaison 86 situé au milieu de la tige 84. Le bloc de liaison 86 se prolonge vers le bas par un bras cylindrique 88. Le bras cylindrique 88 a une extrémité polaire 90 en forme de cône tronqué d'axe Z. Le cône se termine par une face horizontale circulaire 92. Des barreaux verticaux 94 s'étendent à partir des extrémités de la tige 84 et se prolongent horizontalement par des bras convergents 96. Les bras 96 ont des faces inférieures 98 comprises dans un plan horizontal 100 commun aux deux faces et situé à une hauteur H sous la face 92. En vue de dessous, les bras s'approchent de l'axe Z.

A titre d'exemple, les bras 96 s'approchent de l'axe Z selon des directions faisant des angles de l'ordre de 45° avec la direction de la tige horizontale 84. Chaque bras 96 se termine par une extrémité polaire 102. Les extrémités polaires 102 ont deux faces verticales parallèles 104 perpendiculaires à l'axe Y et symétriques par rapport à un plan passant par l'axe Z.

Dans le mode de réalisation représenté, des supports horizontaux 106 s'étendent à partir de chaque extrémité de la tige 84 et permettent de fixer le générateur.

La figure 5 est une vue de dessous partielle d'une variante de circuit magnétique, correspondant au circuit magnétique représenté en figures 4A et 4B dans lequel les bras 96 ont été remplacés par des bras 96' similaires dotés d'extrémités polaires 102'. A la différence des bras 96 des figures 4A et 4B, les bras 96' s'approchent de l'axe Z parallèlement à la direction de la tige horizontale 84. L'axe Z se situe entre des faces verticales parallèles 104' des extrémités polaires 102'. Les faces verticales 104' sont orthogonales à l'axe Y et symétriques par rapport à un plan passant par l'axe Z.

Dans le mode de réalisation illustré en figures 4A et 4B et dans la variante de la figure 5, les bobines 82 sont connectées à des circuits non représentés permettant de faire circuler un courant d'intensité et de sens choisis dans chaque bobine.

Lorsque des courants 108 d'intensités égales et de sens opposés circulent dans les bobines 82, les flux d'induction magnétique créés dans chaque moitié de la tige par chacun des courants s'ajoutent dans le barreau 88. On obtient alors un champ magnétique 82 orienté selon l'axe Z sous la face 92 de l'extrémité polaire 90. Lorsque des courants 110 de même sens circulent dans les bobines, on obtient un champ magnétique dirigé selon l'axe Y. D'une manière générale, une combinaison de courants dans les bobines 82 permet d'obtenir un courant d'intensité réglable et d'orientation choisie dans le plan YZ.

Le générateur de champ magnétique 80 est entièrement situé au-dessus du plan 100 et permet, avec deux bobines seulement, de produire dans un volume situé en dessous du plan 100 un champ magnétique dont on peut régler l'intensité et l'orientation dans le plan YZ.

Dans une variante non représentée, une bobine peut être disposée autour du bras vertical 88, afin d'augmenter l'intensité de la composante du champ magnétique selon l'axe.

Des modes de réalisation particuliers ont été décrits. Diverses variantes et modifications apparaîtront à l'homme de l'art. En particulier, bien que des configurations particulières de circuits magnétiques et de bobines aient été décrites, d'autres configurations sont possibles, l'essentiel étant d'une part que le circuit magnétique comprenne un bras vertical muni d'une extrémité polaire située au-dessus d'un plan horizontal et comprenne au moins deux extrémités polaires symétriques disposées sur le plan horizontal, et d'autre part que chaque portion de circuit magnétique reliant deux des extrémités polaires passe à l'intérieur d'au moins une bobine.

En outre, dans les modes de réalisation décrits, des générateurs de champ magnétique sont utilisés pour tester un point mémoire magnétique formé sur une plaquette de silicium en connectant le point mémoire par des pointes de test. Un générateur du type décrit peut aussi être utilisé pour réaliser des tests magnéto-optiques d'un point mémoire magnétique disposé sur une plaquette, un côté de la plaquette étant alors utilisé par le générateur et l'autre côté restant disponible pour des équipements optiques. On peut également utiliser un tel générateur pour tester plusieurs points mémoire magnétique simultanément, ou pour tester des matrices de points mémoire.

## Revendications

1. Générateur d'un champ magnétique orientable comprenant un circuit magnétique comportant
une première extrémité polaire (37 ; 90) d'axe vertical (Z) disposée au-dessus d'un plan horizontal (29 ; 100), le plan horizontal (29 ; 100) correspondant à un plan perpendiculaire à l'axe vertical (Z) de la première extrémité polaire (37 ; 90); et
au moins une paire de deux deuxièmes extrémités polaires (28A à 28D ; 102 ; 102') disposées symétriquement sur ledit plan horizontal par rapport à au moins un plan contenant l'axe vertical (Z),
le générateur comprenant en outre des bobines (50A à 50D, 52A, 52B ; 82) disposées de telle sorte que chaque portion de circuit magnétique reliant deux des au moins trois extrémités polaires passe à l'intérieur d'au moins une bobine, ces bobines étant adaptées à être connectées à des circuits propres à y faire circuler des courants d'intensités réglables et de sens choisis.

2. Générateur selon la revendication 1, dans lequel les extrémités polaires (28A à 28D ; 102 ; 102') de chaque paire de deuxièmes extrémités polaires voisines ont des faces verticales (40A à 40D, 42A à 42D ; 104 ; 104') parallèles disposées symétriquement par rapport à un plan contenant l'axe vertical (Z).

3. Générateur selon la revendication 1 ou 2, dans lequel la première extrémité polaire (37 ; 90) a la forme d'un cône tronqué ayant une face inférieure circulaire (38 ; 92) disposée à une hauteur (H) comprise entre 0,5 et 5 mm au-dessus dudit plan horizontal (29 ; 100).

4. Générateur selon l'une quelconque des revendications 1 à 3, comprenant deux paires de deux deuxièmes extrémités polaires (28A à 28D) symétriques par rapport à deux plans orthogonaux contenant l'axe vertical (z).

5. Générateur selon la revendication 4, dans lequel chaque extrémité polaire est à l'extrémité d'un bras (26, 36) relié à un cadre (22).

6. Générateur selon la revendication 5, dans lequel le bras (26) associé à chaque deuxième extrémité polaire (28A à 28D) prolonge horizontalement un barreau (24) entouré d'une bobine (50A à 50D).

7. Générateur selon la revendication 5 ou 6, dans lequel le bras (36) associé à la première extrémité polaire (37) est relié à une tige horizontale (32) reliée aux milieux de côtés opposés du cadre (22), une bobine (52A, 52B) étant disposée autour de chaque moitié de la tige horizontale.

8. Générateur selon la revendication 6 ou 7, dans lequel le bras (36) associé à la première extrémité polaire (37) est entouré d'une des bobines du générateur.

9. Générateur selon l'une quelconque des revendications 1 à 3, comprenant une paire de deux deuxièmes extrémités polaires (102 ; 102'), chacune des première et deuxièmes extrémités polaires (90 ; 102 102') étant à l'extrémité (88, 96, 96') d'un bras relié à une tige (84), le bras (88) associé à la première extrémité polaire étant relié au centre de la tige, et une bobine (82) parmi les bobines du générateur étant disposée autour de chaque moitié de la tige.

10. Générateur selon la revendication 9, dans lequel le bras (88) associé à la première extrémité polaire (90) est entouré d'une des bobines du générateur.

## Patentansprüche

1. Generator für ein orientierbares Magnetfeld, einen Magnetkreis umfassend, der aufweist
ein erstes Polende (37; 90) mit vertikaler Achse (Z), das über einer horizontalen Ebene (29; 100) angeordnet ist, wobei die horizontale Ebene (29; 100) einer Ebene senkrecht zur vertikalen Achse (Z) des ersten Polendes (37; 90) entspricht; und
mindestens ein Paar von zwei zweiten Polenden (28A bis 28D; 102; 102'), die symmetrisch auf der horizontalen Ebene in Bezug auf mindestens eine Ebene angeordnet sind, die die vertikale Achse (Z) enthält,
wobei der Generator außerdem Wicklungen (50A bis 50D; 52A, 52B; 82) umfasst, die derart angeordnet sind, dass jeder Teil des Magnetkreises, der zwei der mindestens drei Polenden verbindet, innerhalb mindestens einer Wicklung verläuft, wobei diese Wicklungen angepasst sind, mit Schaltkreisen verbunden zu werden, die geeignet sind, darin Ströme mit einstellbarer Stärke und gewählter Richtung fließen zu lassen.

2. Generator nach Anspruch 1, bei dem die Polenden (28A bis 28D; 102; 102') jedes Paares von zwei benachbarten Polenden vertikale parallele Flächen (40A bis 40D, 42A bis 42D; 104; 104') aufweisen, die symmetrisch in Bezug auf eine die vertikale Ebene (Z) enthaltende Ebene angeordnet sind.

3. Generator nach Anspruch 1 oder 2, bei dem das erste Polende (37; 90) die Form eines Kegelstumpfes aufweist, der eine kreisförmige untere Fläche (38; 92) aufweist, die an einer Höhe (H) angeordnet ist, die zwischen 0,5 und 5 mm über der horizontalen Ebene (29; 100) liegt.

4. Generator nach einem beliebigen der Ansprüche 1 bis 3, zwei Paare von zwei zweiten Polenden (28A bis 28D) umfassend, die in Bezug auf zwei, die vertikale Achse (Z) enthaltenden orthogonalen Ebenen symmetrisch sind.

5. Generator nach Anspruch 4, bei dem jedes Polende am Ende eines Arms (26, 36) liegt, der mit einem Rahmen (22) verbunden ist.

6. Generator nach Anspruch 5, bei dem der jedem zweiten Polende (28A bis 28D) zugeordnete Arm (26) horizontal einen Stab (24) verlängert, der von einer Wicklung (50A bis 50D) umgeben ist.

7. Generator nach Anspruch 5 oder 6, bei dem der dem ersten Polende (37) zugeordnete Arm (36) an einen horizontalen Stab (32) angeschlossen ist, der mit den Mitten von gegenüberliegenden Seiten des Rahmens (22) verbunden ist, wobei eine Wicklung (52A, 52B) um jede Hälfte des horizontalen Stabes angeordnet ist.

8. Generator nach Anspruch 6 oder 7, bei dem der dem ersten Polende (37) zugeordnete Arm (37) von einer der Wicklungen des Generators umgeben ist.

9. Generator nach einem beliebigen der Ansprüche 1 bis 3, ein Paar von zwei zweiten Polende (102; 102') umfassend, wobei jedes des ersten und zweiten Polendes (90; 102; 102') am Ende (88, 96, 96') eines Arms, der an einen Stab (84) angeschlossen ist, liegt, wobei der dem ersten Polende zugeordnete Arm (88) mit der Mitte des Stabes verbunden ist und eine Wicklung (82) von den Wicklungen des Generators um jede Hälfte des Stabes herum angeordnet ist.

10. Generator nach Anspruch 9, bei dem der dem ersten Polende zugeordnete Arm (90) von einer Wicklung des Generators umgeben ist.

## Claims

1. A generator of a magnetic field of adjustable direction including a magnetic circuit comprising:
a first polar end (37; 90) of vertical axis (Z) arranged above a horizontal plane (29; 100), the horizontal plane (29; 100) corresponding to a plane perpendicular to a vertical axis (8) of the first polar end (37 ; 90) ; and
at least a pair of two second polar ends (28A to 28D; 102; 102') arranged symmetrically on said horizontal plane with relation to at least a plane comprising a vertical axis (Z),
the generator further comprising coils (50A to 50D, 52A, 52B; 82) arranged so that each magnetic circuit portion connecting two of the at least three polar ends runs inside at least one coil, the coils being adapted to be connected to circuits configured to conduct currents of settable intensities and of selected directions therethrough.

2. The generator according to claim 1, wherein the polar ends (28A to 28D; 102; 102') of each pair of second neighboring polar ends have parallel vertical surfaces (40A to 40D, 42A to 42D; 104; 104') arranged symmetrically with respect to a plane containing the vertical axis (Z).

3. The generator according to claim 1 or 2, wherein the first polar end (37; 90) has the shape of a truncated cone having a circular lower surface (38; 92) arranged at a height (H) in the range from 0.5 to 5 mm above said horizontal plane (29; 100).

4. The generator according to any one of claims 1 to 3, comprising two pairs of two second polar ends (28A to 28D) symmetrical with respect to two orthogonal planes containing the vertical axis (Z).

5. The generator according to claim 4, wherein each polar end is at the end of an arm (26, 36) connected to a frame (22).

6. The generator according to claim 5, wherein the arm (26) associated with each second polar end (28A to 28D) horizontally extends a bar (24) surrounded with a coil (50A to 50D).

7. The generator according to claim 5 or 6, wherein the arm (36) associated with the first polar end (37) is connected to a horizontal rod (32) connected to the middles of opposite sides of the frame (22), a coil (52A, 52B) being arranged around each half of the horizontal rod.

8. The generator according to claim 6 or 7, wherein the arm (36) associated with the first polar end (37) is surrounded with one of the coils of the generator.

9. The generator according to any of claims 1 to 3, comprising a pair of two second polar ends (102; 102'), each of the first and second polar ends (90; 102; 102') being at the end (88, 96, 96') of an arm connected to a rod (84), the arm (88) associated with the first polar end being connected to the center of the rod, and a coil (82) being arranged around each half of the rod.

10. The generator according to claim 9, wherein the arm (88) associated with the first polar end (90) is surrounded with one of the coils of the generator.
